# EUROPEAN PATENT APPLICATION

(11) **EP 3 293 777 A1**
(43) Date of publication of application: **14.03.2018**
(21) Application number: 15883647.8
(22) Date of filing: 17.11.2015
(51) Int. Cl.: H01L 51/56, H01L 51/52, H01L 51/54

(54) **OLED DEVICE PACKAGE STRUCTURE, PACKAGE METHOD AND ELECTRONIC APPARATUS**

(30) Priority: 07.05.2015 CN 201510227868
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: ZHAO, Deyou, Beijing 100176 (CN); WANG, Yongmao, Beijing 100176 (CN)
(74) Representative: Fritzsche, Thomas
(86) International application number: PCT/CN2015/094801
(87) International publication number: WO 2016/176980

(57) **Abstract**

The embodiments of the present invention provide a packaging structure for OLED device, packaging method and electronic equipment. According to the embodiments of the invention, an anaerobic sealant is applied in the OLED packaging process as a packaging material. Since anaerobic sealant can be cured at room temperature without heat curing or UV curing, the technological process can be simplified, saving the cost. Meanwhile, the OLED process per se should be performed in a vacuum or inert gas environment (i.e., an anaerobic environment), which is advantageous for applying the anaerobic sealant; therefore no more investment is required, and the cost is saved. Moreover, the bonding strength of the cured anaerobic sealant is relatively strong, thus the sealed bonding between the cover plate and the substrate can be realized without an additional dam coating process, simplifying the technological process.

## Description

### FIELD OF THE INVENTION

The present invention relates to the field of display technology, particularly to a packaging structure for OLED device, packaging method and electronic equipment.

### BACKGROUND OF THE INVENTION

OLED (Organic Light-Emitting Diode) display device emits light since two kinds of carriers (i.e., electrons and holes) are injected into an organic material film and recombine in the organic material. OLED is a solid-state, active light emitting device, with characteristics such as high brightness, high contrast, lightness, small thickness, low power consumption, large range of view angle and wide range of working temperature, which is considered to be the next generation display device for replacing liquid crystal display.

The biggest disadvantage of OLED is short lifetime, which is also a technical problem hindering the development of the OLED industry. The main factors affecting the lifetime of OLED are moisture in the atmosphere and oxygen in the air. Moisture and oxygen can cause chemical reactions and failures in the films of OLED device, resulting in a shortened lifetime for the device. Therefore, the OLED packaging process is particularly important.

At present, the OLED packaging process mainly comprises the traditional packaging process and inorganic-organic thin film packaging process. The traditional packaging process comprises adding a glass or metal cover plate on OLED device in a dry inert gas (for example: nitrogen or argon) environment, and performing sealed connecting with UV curing resin; such a packaging process has the advantages of simplicity, low cost; however, the resin has a poor compactness, and is prone to cracking and embrittlement, greatly reducing the lifetime of OLED device. Inorganic-organic thin film packaging process is realized with physical and chemical vapor deposition technology; this package can form a good barrier layer film, but the production process is complex, the packaging equipment is expensive, and the operating conditions are harsh.

### SUMMARY OF THE INVENTION

Therefore, the embodiments of the present invention provide a packaging structure for OLED device, packaging method and electronic equipment, simplifying the process, reducing the cost, improving the packaging effect, and prolonging the life time of OLED device.

An embodiment of the present invention provides a packaging structure for OLED device. The packaging structure for OLED device comprises: a basal substrate, an OLED device arranged on a surface of the basal substrate, a sealant covering the OLED device and overlapping with the surface of the basal substrate, and a cover plate covering the sealant. The sealant consists of an anaerobic sealant; alternatively, the sealant consists of an anaerobic sealant and a frame sealant surrounding the anaerobic sealant.

According to the embodiments of the invention, an anaerobic sealant is applied in the OLED packaging process as a packaging material. Since anaerobic sealant can be cured at room temperature without heat curing or UV curing, the technological process can be simplified, saving the cost. Meanwhile, the OLED process per se should be performed in a vacuum or inert gas environment (i.e., an anaerobic environment), which is advantageous for applying the anaerobic sealant; therefore no more investment is required, and the cost is saved. Moreover, the bonding strength of the cured anaerobic sealant is relatively strong, thus the sealed bonding between the cover plate and the substrate can be realized without an additional dam coating process, simplifying the technological process.

Optionally, the cover plate is a glass cover plate, a metal cover plate or a plastic cover plate.

Optionally, the basal substrate is a glass substrate or a flexible substrate.

Optionally, the anaerobic sealant consists of a single component material of methacrylate.

Optionally, the anaerobic sealant is a modified anaerobic sealant.

Optionally, the modified anaerobic sealant comprises dimethacrylate, modifier, additive, filler, oxidation reduction catalyst and stabilizer.

An embodiment of the present invention also provides a packaging method for OLED device. The method comprises: providing a basal substrate, an OLED device being arranged on a surface of the basal substrate; applying a sealant on the basal substrate, the sealant covering the OLED device and overlapping with the surface of the basal substrate; and attaching a cover plate on the sealant. The sealant consists of an anaerobic sealant; alternatively, the sealant consists of an anaerobic sealant and a frame sealant surrounding the anaerobic sealant.

According to the embodiments of the invention, an anaerobic sealant is applied in the OLED packaging process as a packaging material. Since anaerobic sealant can be cured at room temperature without heat curing or UV curing, the technological process can be simplified, saving the cost. Meanwhile, the OLED process per se should be performed in a vacuum or inert gas environment (i.e., an anaerobic environment), which is advantageous for applying the anaerobic sealant; therefore no more investment is required, and the cost is saved. Moreover, the bonding strength of the cured anaerobic sealant is relatively strong, thus the sealed bonding between the cover plate and the substrate can be realized without an additional dam coating process, simplifying the technological process.

Optionally, applying a sealant on the basal substrate, the sealant covering the OLED device and overlapping with the surface of the basal substrate comprises: applying an anaerobic sealant on the surface of the basal substrate in an inert gas environment; alternatively, disposing a frame sealant on the surface of the basal substrate in an inert gas environment, and applying an anaerobic sealant in a region defined by the frame sealant.

Optionally, the method further comprises: after attaching a cover plate on the sealant, performing heat curing or UV curing to the frame sealant.

Optionally, the cover plate is a glass cover plate, a metal cover plate or a plastic cover plate.

Optionally, the basal substrate is a glass substrate or a flexible substrate.

Optionally, the anaerobic sealant consists of a single component material of methacrylate.

Optionally, the anaerobic sealant is a modified anaerobic sealant.

Optionally, the modified anaerobic sealant comprises dimethacrylate, modifier, additive, filler, oxidation reduction catalyst and stabilizer.

An embodiment of the present invention also provides an electronic equipment, which comprises the packaging structure for OLED device provided by the embodiment of the invention.

### BRIEF DESCRIPTION OF THE DRAWINGS

Fig. 1 is a structural schematic diagram of a packaging structure for OLED device provided by an embodiment of the present invention; and
Fig. 2 is a structural schematic diagram of a packaging structure for OLED device provided by another embodiment of the present invention.

### DETAILED DESCRIPTION OF THE INVENTION

In the following, the packaging structure for OLED device, packaging method and electronic equipment provided by the embodiments of the invention will be described clearly and completely in connection with the drawings in the embodiments of the invention.

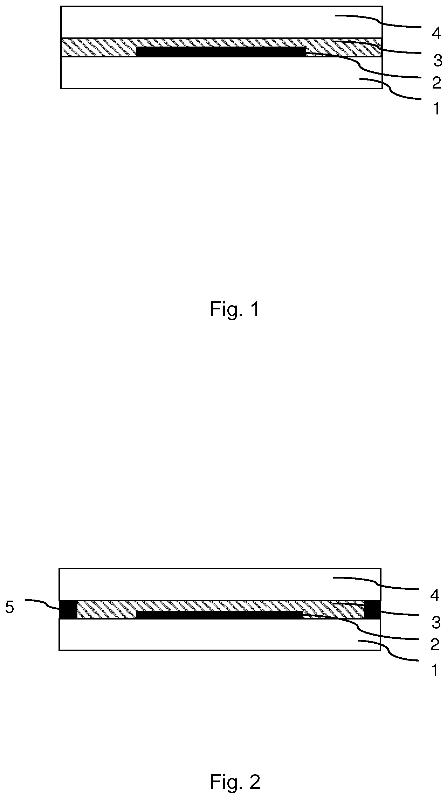

Fig. 1 is a structural schematic diagram of a packaging structure for OLED device provided by an embodiment of the present invention. The packaging structure for OLED device comprises: a basal substrate 1, an OLED device 2 arranged on a surface of the basal substrate 1, a sealant covering the OLED device and overlapping with the surface of the basal substrate, and a cover plate 4 covering the sealant. The sealant consists of an anaerobic sealant 3.

Fig. 2 is a structural schematic diagram of a packaging structure for OLED device provided by another embodiment of the present invention. The packaging structure for OLED device comprises: a basal substrate 1, an OLED device 2 arranged on a surface of the basal substrate 1, a sealant covering the OLED device and overlapping with the surface of the basal substrate, and a cover plate 4 covering the sealant. The sealant consists of an anaerobic sealant 3 and a frame sealant 5 surrounding the anaerobic sealant 3.

In the context of the present invention, "surrounding the anaerobic sealant" means enclosing the anaerobic sealant laterally as show in Fig. 2, rather than covering the upper surface of the anaerobic sealant.

According to the embodiments of the invention, an anaerobic sealant is applied in the OLED packaging process as a packaging material. Since anaerobic sealant can be cured at room temperature without heat curing or UV curing, the technological process can be simplified, saving the cost. Meanwhile, the OLED process per se should be performed in a vacuum or inert gas environment (i.e., an anaerobic environment), which is advantageous for applying the anaerobic sealant; therefore no more investment is required, and the cost is saved. Moreover, the bonding strength of the cured anaerobic sealant is relatively strong, thus the sealed bonding between the cover plate and the substrate can be realized without an additional dam coating process, simplifying the technological process.

In the structural schematic diagram of the packaging structure for OLED device provided by another embodiment of the present invention shown in Fig. 2, after arranging the frame sealant, anaerobic sealant and cover plate in sequence, the frame sealant can be cured immediately without waiting for curing of the anaerobic sealant. Therefore, though a frame sealant is applied, a better packaging effect can be achieved, and the time efficiency is also improved.

Optionally, the cover plate 4 is a glass cover plate, a metal cover plate or a plastic cover plate.

Anaerobic sealant has a relatively strong bonding strength, which is suitable for bonding glass cover plate, metal cover plate or plastic cover plate with various applications.

Optionally, the basal substrate 1 is a glass substrate or a flexible substrate.

Anaerobic sealant has a relatively strong bonding strength, which is suitable for bonding glass substrate or flexible substrate with various applications.

Optionally, the anaerobic sealant consists of a single component material of methacrylate.

Anaerobic sealant consisting of a single component material of methacrylate has characteristics such as moderate intensity and rapid curing; therefore anaerobic sealant is suitable for the embodiments of the present invention.

Optionally, the anaerobic sealant is a modified anaerobic sealant.

Modified anaerobic sealant has advantages such as high temperature resistance, low temperature resistance, rapid curing, and stable physical properties; therefore modified anaerobic sealant is suitable for the embodiments of the present invention.

Optionally, the modified anaerobic sealant comprises dimethacrylate, modifier, additive, filler, oxidation reduction catalyst and stabilizer.

An embodiment of the present invention also provides a packaging method for OLED device. The method comprises: providing a basal substrate, an OLED device being arranged on a surface of the basal substrate; applying a sealant on the basal substrate, the sealant covering the OLED device and overlapping with the surface of the basal substrate; and attaching a cover plate on the sealant. The sealant consists of an anaerobic sealant; alternatively, the sealant consists of an anaerobic sealant and a frame sealant surrounding the anaerobic sealant.

According to the embodiments of the invention, an anaerobic sealant is applied in the OLED packaging process as a packaging material. Since anaerobic sealant can be cured at room temperature without heat curing or UV curing, the technological process can be simplified, saving the cost. Meanwhile, the OLED process per se should be performed in a vacuum or inert gas environment (i.e., an anaerobic environment), which is advantageous for applying the anaerobic sealant; therefore no more investment is required, and the cost is saved. Moreover, the bonding strength of the cured anaerobic sealant is relatively strong, thus the sealed bonding between the cover plate and the substrate can be realized without an additional dam coating process, simplifying the technological process.

Optionally, applying a sealant on the basal substrate, the sealant covering the OLED device and overlapping with the surface of the basal substrate comprises: applying an anaerobic sealant on the surface of the basal substrate in an inert gas environment; alternatively, disposing a frame sealant on the surface of the basal substrate in an inert gas environment, and applying an anaerobic sealant in a region defined by the frame sealant.

The OLED process per se should be performed in a vacuum or inert gas environment (i.e., an anaerobic environment), which is advantageous for applying the anaerobic sealant; therefore no more investment is required, saving the cost.

Optionally, the method further comprises: after attaching a cover plate on the sealant, performing heat curing or UV curing to the frame sealant.

After arranging the frame sealant, anaerobic sealant and cover plate in sequence, the frame sealant can be cured immediately without waiting for curing of the anaerobic sealant. Therefore, though a frame sealant is applied, a better packaging effect can be achieved, and the time efficiency is also improved.

Optionally, the cover plate is a glass cover plate, a metal cover plate or a plastic cover plate.

Anaerobic sealant has a relatively strong bonding strength, which is suitable for bonding glass cover plate, metal cover plate or plastic cover plate with various applications.

Optionally, the basal substrate is a glass substrate or a flexible substrate.

Anaerobic sealant has a relatively strong bonding strength, which is suitable for bonding glass substrate or flexible substrate with various applications.

Optionally, the anaerobic sealant consists of a single component material of methacrylate.

Anaerobic sealant consisting of a single component material of methacrylate has characteristics such as moderate intensity and rapid curing; therefore anaerobic sealant is suitable for the embodiments of the present invention.

Optionally, the anaerobic sealant is a modified anaerobic sealant.

Modified anaerobic sealant has advantages such as high temperature resistance, low temperature resistance, rapid curing, and stable physical properties; therefore modified anaerobic sealant is suitable for the embodiments of the present invention.

Optionally, the modified anaerobic sealant comprises dimethacrylate, modifier, additive, filler, oxidation reduction catalyst and stabilizer.

It can be understood by those skilled in the art that a mixture of conventional frame sealant and anaerobic sealant can also be used as the frame sealant in the embodiment of the present invention.

Two examples are provided to respectively illustrate the packaging method of the packaging structure for OLED device as shown in Fig. 1 and Fig. 2.

### Example 1:

As shown in Fig. 1, after an OLED device 2 is formed on a basal substrate 1, an anaerobic sealant 3 is applied on the OLED device 2 with spray, spin coating or surface coating process in an inert gas environment; then a cover plate 4 is attached on the anaerobic sealant 3; the anaerobic sealant 3 can be cured sufficiently within 1-2 hours in a stationary environment. This implementation is suitable for anaerobic sealant of rapid curing type, such as anaerobic sealant consisting of a single component material of methacrylate. For example, LOCTITE™ 577 anaerobic sealant is a rapid curing thixotropic anaerobic sealant with single component (dimethacrylate) and moderate intensity. Moreover, by mixing salt of benzoic sulfimide and 1,2,3,4-tetrahydrochinoline (STQ salt) and a small amount of peroxide initiator and water, an anaerobic sealant can be obtained, which can be cured within 1 min.

### Example 2:

As shown in Fig. 2, after an OLED device 2 is formed on a basal substrate 1, a frame sealant 5 of UV curing type or heat curing type is coated on the periphery of the basal substrate 1 in an inert gas environment; an anaerobic sealant 3 is applied on the OLED device 2 with spray, spin coating or surface coating process; then a cover plate 4 is attached on the anaerobic sealant 3 and the frame sealant 5; finally, the frame sealant 5 can be cured with UV curing process or heat curing process. Compared with example 1, the process of example 2 is more complex, the cost is higher. However, after arranging the frame sealant, anaerobic sealant and cover plate in sequence, the frame sealant can be cured immediately without waiting for curing of the anaerobic sealant. Therefore, though a frame sealant is applied, a better packaging effect can be achieved, and the time efficiency is also improved.

Based on the same inventive concept, an embodiment of the present invention provides an electronic equipment, which comprises the packaging structure for OLED device provided the embodiment of the present invention. The electronic equipment can be any product or component with lighting or display function, such as lighting equipment, mobile phone, tablet computer, TV, display, notebook computer, digital photo frame and navigator. The implementation of the electronic equipment can refer to the embodiments of the above mentioned packaging structure for OLED device, which will not be repeated herein.

Apparently, the person skilled in the art may make various alterations and variations to the invention without departing the spirit and scope of the invention. As such, provided that these modifications and variations of the invention pertain to the scope of the claims of the invention and their equivalents, the invention is intended to embrace these alterations and variations.

## Claims

1. A packaging structure for OLED device comprising: a basal substrate, an OLED device arranged on a surface of the basal substrate, a sealant covering the OLED device and overlapping with the surface of the basal substrate, and a cover plate covering the sealant;
wherein the sealant consists of an anaerobic sealant; alternatively, the sealant consists of an anaerobic sealant and a frame sealant surrounding the anaerobic sealant.

2. The packaging structure for OLED device according to claim 1, wherein the cover plate is a glass cover plate, a metal cover plate or a plastic cover plate.

3. The packaging structure for OLED device according to claim 1, wherein the basal substrate is a glass substrate or a flexible substrate.

4. The packaging structure for OLED device according to claim 1, wherein the anaerobic sealant consists of a single component material of methacrylate.

5. The packaging structure for OLED device according to claim 1, wherein the anaerobic sealant is a modified anaerobic sealant.

6. The packaging structure for OLED device according to claim 5, wherein the modified anaerobic sealant comprises dimethacrylate, modifier, additive, filler, oxidation reduction catalyst and stabilizer.

7. A packaging method for OLED device, comprising:
providing a basal substrate, an OLED device being arranged on a surface of the basal substrate;
applying a sealant on the basal substrate, the sealant covering the OLED device and overlapping with the surface of the basal substrate; and
attaching a cover plate on the sealant;
wherein the sealant consists of an anaerobic sealant; alternatively, the sealant consists of an anaerobic sealant and a frame sealant surrounding the anaerobic sealant.

8. The packaging method for OLED device according to claim 7, wherein applying a sealant on the basal substrate, the sealant covering the OLED device and overlapping with the surface of the basal substrate comprises:
applying an anaerobic sealant on the surface of the basal substrate in an inert gas environment;
alternatively, disposing a frame sealant on the surface of the basal substrate in an inert gas environment, and applying an anaerobic sealant in a region defined by the frame sealant.

9. The packaging method for OLED device according to claim 7, further comprising: after attaching a cover plate on the sealant, performing heat curing or UV curing to the frame sealant.

10. The packaging method for OLED device according to claim 7, wherein the cover plate is a glass cover plate, a metal cover plate or a plastic cover plate.

11. The packaging method for OLED device according to claim 7, wherein the basal substrate is a glass substrate or a flexible substrate.

12. The packaging method for OLED device according to claim 7, wherein the anaerobic sealant consists of a single component material of methacrylate.

13. The packaging method for OLED device according to claim 7, wherein the anaerobic sealant is a modified anaerobic sealant.

14. The packaging method for OLED device according to claim 13, wherein the modified anaerobic sealant comprises dimethacrylate, modifier, additive, filler, oxidation reduction catalyst and stabilizer.

15. An electronic equipment comprising the packaging structure for OLED device according to any one of claims 1-6.
